# EUROPÄISCHE PATENTSCHRIFT

(11) **EP 3 263 740 B1**
(45) Veröffentlichungstag und Bekanntmachung des Hinweises auf die Patenterteilung: **18.11.2020**
(21) Anmeldenummer: 17174215.8
(22) Anmeldetag: 02.06.2017
(51) Int. Cl.: C23C 16/458

(54) **WERKSTÜCKTRÄGER UND VERFAHREN ZUR HERSTELLUNG EINES WERKSTÜCKTRÄGERS**
WORKPIECE HOLDER AND METHOD FOR PRODUCING SAME
PORTE-PIÈCE ET SON PROCÉDÉ DE FABRICATION

(30) Priorität: 29.06.2016 DE 102016211775
(43) Veröffentlichungstag der Anmeldung: 03.01.2018
(73) Patentinhaber: Schunk Kohlenstofftechnik GmbH, 35452 Heuchelheim (DE)
(72) Erfinder: SPENLER, Anna-Lena, 35452 Heuchelheim (DE); STROBEL, Thomas, 61250 Usingen (DE)
(74) Vertreter: advotec.

(56) Entgegenhaltungen:
- CN-A- 102 534 565
- DE-A1-102006 036 624
- DE-U1- 20 319 600
- DE-U1-202008 013 163
- US-A- 5 759 621
- US-A1- 2005 100 852
- US-A1- 2012 171 375
- US-A1- 2014 178 596
- US-A1- 2014 245 956

## Beschreibung

Die Erfindung betrifft einen Werkstückträger sowie ein Verfahren zur Herstellung eines Werkstückträgers zum Bereitstellen und Handhaben von Werkstücken in Hochtemperaturöfen zur Werkstückbeschichtung oder dergleichen, wobei der Werkstückträger aus einer Trägerplatte mit aus einer Plattenebene der Trägerplatte vorspringenden Werkstückaufnahmen ausgebildet ist, wobei der Werkstückträger aus einem Kohlenstoffmaterial ausgebildet ist.

Derartige Werkstückträger sind hinreichend bekannt und werden regelmäßig zur Aufnahme und zum Transport von Werkstücken im Rahmen eines Beschichtungsprozesses verwandt. Unter einem Beschichtungsprozess wird hier eine Beschichtung eines Werkstücks in einem Hochtemperaturofen im Rahmen eines CVD- oder CVI-Verfahrens beziehungsweise einer Beschichtung des Werkstücks aus einer Gasphase verstanden. Dabei wird eine Oberfläche des Werkstücks mit einem Metallcarbid, Metallnitrit, Metallhydroxid oder Metalloxyd beschichtet, um in der Regel eine Verbesserung der Eigenschaften des betreffenden Werkstücks zu erzielen. Beispielsweise ist es bekannt, Wendeschneidplatten mit Titancarbid oder Titannitrit auf diese Weise zu beschichten. Bei den bekannten Beschichtungsverfahren wird stets versucht eine große Anzahl von Werkstücken auf Werkstückträgern so anzuordnen, dass ein Innenraum eines Hochtemperaturofens möglichst dicht mit Werkstücken ausgefüllt ist, um die Kosten des Beschichtungsverfahrens gering zu halten. Dabei müssen die Werkstücke auf dem Werkstückträger so angeordnet sein, dass die Werkstücke möglichst allseitig beziehungsweise an den wesentlichen Oberflächenbereichen mit Beschichtungsmaterial beschichtet werden. Eine zu dichte Anordnung von Werkstücken hat gegebenenfalls eine Ausbildung von Abschattungen mit einem unzureichenden Niederschlag von Beschichtungsmaterial auf dem Werkstück zur Folge.

Gattungsgemäße Werkstückträger sind aus den Druckschriften US 2005 100852 A1, DE 20 2008 013163 U1, DE 203 19 600 U1, US 5 759 621 A, DE 10 2006 036624 A1 und CN 102 534 565 A bekannt.

Die bekannten Werkstückträger sind regelmäßig plattenförmig beziehungsweise aus einer Trägerplatte mit Werkstückaufnahmen ausgebildet. Aus einer Plattenebene der Trägerplatte springen Werkstückaufnahmen hervor beziehungsweise stehen aus der Plattenebene so hervor, dass ein Werkstück auf einer oder mehreren Werkstückaufnahmen so platziert werden kann, dass das Werkstück nicht auf der Trägerplatte direkt aufliegt. Die Trägerplatte und die Werkstückaufnahmen sind aus einem Kohlenstoffmaterial beziehungsweise aus einer Modifikation von Kohlenstoff, wie beispielsweise Graphit ausgebildet, da dieses Material vergleichsweise unempfindlich gegenüber einem wiederholten Einsatz in einem der beschriebenen Beschichtungsverfahren ist.

So sind plattenförmige Werkstückträger aus Graphit bekannt, die einstückig ausgebildet sind, wobei aus einer Plattenebene pyramidenförmig ausgebildete Werkstückaufnahmen herausragen, auf denen Werkstücke platziert werden können. Bei einem Beschichten von Werkstücken wird dann auch eine Oberfläche des Werkstückträgers mit dem Beschichtungsmaterial beschichtet. Der Werkstückträger kann dann nur eine gewisse Anzahl von Ofenfahrten beziehungsweise Beschichtungsvorgängen verwendet werden, da sonst eine Beschichtung auf der Oberfläche des Walzstückträgers zu dick wird. Wenn eine bestimmte Dicke der Beschichtung auf der Oberfläche des Werkstückträgers erreicht ist, ist es erforderlich, den Werkstückträger gegen einen neuen Werkstückträger zu ersetzen. Da derartige Werkstückträger nur kostenaufwendig herzustellen sind, können beschichtete Werkstückträger aus Gründen der Wirtschaftlichkeit auch entschichtet werden. Je nach Beschichtungsmaterial erfolgt eine Entschichtung thermisch, in einer Base oder Säure und/oder mechanisch, wobei das Kohlenstoffmaterial des Werkstückträgers keinen Schaden nimmt und der Werkstückträger dann wieder verwendbar ist.

Wenn der Werkstückträger einstückig und vollständig aus Graphit ausgebildet ist, weist der Werkstückträger auch eine geringe Porosität auf, was vorteilhaft ist. Bei dem Beschichten mit Beschichtungsmaterial kann dann nur wenig Beschichtungsmaterial in die Poren des Graphits eindringen, wodurch insgesamt auch weniger Beschichtungsmaterial benötigt wird. Auch kommt es dann weniger häufig zu einem Reißen des Werkstückträgers infolge von Wärmespannungen. So weist das Beschichtungsmaterial gegenüber dem Graphit einen wesentlich abweichenden Wärmeausdehnungskoeffizienten auf, was bei einem Eindringen von Beschichtungsmaterial in die Poren des Graphits Rissbildungen im Werkstückträger begünstigt. Insbesondere können bei einem Entschichten des Werkstückträgers diese Risse sichtbar werden bzw. der Werkstückträger auseinanderbrechen. Weiter soll ein Abplatzen von Beschichtungsmaterial von dem Werkstückträger verhindert werden, da dann während eines Beschichtungsprozesses abplatzendes Beschichtungsmaterial auf Werkstücke fallen kann, die dann ungleichmäßig beschichtet werden und somit nicht mehr nutzbar sind.

Der vorliegenden Erfindung liegt daher die Aufgabe zugrunde, einen Werkstückträger und ein Verfahren zur Herstellung eines Werkstückträgers vorzuschlagen, durch den beziehungsweise das ein Beschichtungsprozess kostengünstiger durchgeführt werden kann.

Diese Aufgabe wird durch einen Werkstückträger mit den Merkmalen des Anspruchs 1, ein Verfahren zur Instandsetzung mit den Merkmalen des Anspruchs 16, durch eine Verwendung von kohlenstofffaserverstärktem Kohlenstoff mit den Merkmalen des Anspruchs 17 und ein Verfahren zur Herstellung eines Werkstückträgers mit den Merkmalen des Anspruchs 18 gelöst.

Bei dem erfindungsgemäßen Werkstückträger zum Bereitstellen und Handhaben von Werkstücken in Hochtemperaturöfen zur Werkstückbeschichtung oder dergleichen, ist der Werkstückträger aus einer Trägerplatte mit aus einer Plattenebene der Trägerplatte vorspringenden Werkstückaufnahmen ausgebildet, wobei der Werkstückträger aus einem Kohlenstoffmaterial ausgebildet ist, wobei der Werkstückträger mehrteilig ausgebildet ist, wobei zumindest die Trägerplatte aus kohlenstofffaserverstärktem Kohlenstoff ausgebildet ist.

Wesentlich ist, dass der erfindungsgemäße Werkstückträger vollständig aus einem Kohlenstoffmaterial ausgebildet ist, da dies auch ein Entschichten des Werkstückträgers und damit eine Wiederverwendung ermöglicht. Eventuell an dem Werkstückträger verbaute Metalle würden bei einem Entschichtungsprozess, wie auch das Beschichtungsmaterial, mit entfernt werden. Der Werkstückträger ist daher metallfrei ausgebildet. Die Trägerplatte aus kohlenstofffaserverstärktem Kohlenstoff weist eine vergleichsweise große Porosität gegenüber Graphit auf, was als nachteilig angesehen werden könnte. Jedoch können Kohlenstofffasern des kohlenstofffaserverstärkten Kohlenstoffs eventuelle Wärmespannungen in der Trägerplatte so weit aufnehmen, dass es in keinem Fall zu einem Reißen beziehungsweise zu einer Rissbildung in der Trägerplatte kommen kann. Die Trägerplatte beziehungsweise der Werkstückträger wird durch die Möglichkeit der Entschichtung und durch die verbesserte Festigkeit der Trägerplatte infolge der Verwendung von kohlenstofffaserverstärktem Kohlenstoff zur Ausbildung der Trägerplatte mehrfach und bruchsicher verwendbar und damit kostengünstig nutzbar. Darüber hinaus ermöglicht die vergleichsweise große Porosität des kohlenstofffaserverstärkten Kohlenstoffs eine besonders gute Haftung des Beschichtungsmaterials an der Trägerplatte, weshalb ein Abplatzen von Beschichtungsmaterial von der Trägerplatte, und damit eine Beschädigung von Werkstücken, verhindert werden kann. Weiter kann die Trägerplatte gegenüber einer Trägerplatte aus Graphit vergleichsweise dünn ausgebildet werden, wodurch mehr Trägerplatten beziehungsweise mehr Werkstücke in einem Innenraum eines Beschichtungsofens angeordnet werden können. Zwar ist kohlenstofffaserverstärkter Kohlenstoff als Werkstoff wesentlich teurer als Graphit, jedoch wird der Werkstückträger durch die verbesserte Wiederverwendbarkeit häufiger nutzbar. Auch durch die mehrteilige Ausbildung des Werkstückträgers aus verschiedenen Einzelteilen bzw. aus der Trägerplatte und den davon getrennt hergestellten Werkstückaufnahmen wird es möglich, die Trägerplatte einfach aus kohlenstofffaserverstärkten Kohlenstoff herzustellen. Insgesamt kann so ein Beschichtungsprozess mittels des Werkstückträgers wesentlich kostengünstiger durchgeführt werden.

In einer Ausführungsform können die Werkstückaufnahmen aus kohlenstofffaserverstärktem Kohlenstoff ausgebildet sein. Die Werkstückaufnahmen können dann zusammen mit der Trägerplatte so ausgebildet werden, dass der Werkstückträger einstückig ist. Alternativ ist es möglich, die Werkstückaufnahmen getrennt von der Trägerplatte aus dem kohlenstofffaserverstärkten Kohlenstoff auszubilden und an der Trägerplatte zu montieren beziehungsweise zu befestigen. Wesentlich dabei ist, dass die Werkstückaufnahmen dann nach einer Montage an der Trägerplatte aus der Plattenebene der Trägerplatte hervorstehen beziehungsweise herausragen.

Alternativ können die Werkstückaufnahmen auch aus Graphit ausgebildet sein. Dass eine Oberfläche der Werkstückaufnahmen im Vergleich zu einer Oberfläche der Trägerplatte vergleichsweise klein ist, wirkt sich nicht nachteilig aus. Vielmehr können die Werkstückaufnahmen auch besonders einfach kostengünstig hergestellt werden. Dadurch, dass die Werkstückaufnahmen keine große Oberfläche ausbilden, besteht nicht die Gefahr von Spannungsrissen infolge von Wärmespannungen.

Weiter weist die Trägerplatte ein Lochraster auf. Das Lochraster kann so ausgestaltet sein, dass in regelmäßigen Abständen Durchgangsöffnungen beziehungsweise Bohrungen in der Trägerplatte ausgebildet sind. Dies ermöglicht eine gute, ggf. verwirbelungsfreie Durchdringung bzw. Durchströmung einer Stapelanordnung von Werkstückträgern mit noch gasförmigem Beschichtungsmaterial, wodurch eine Ausbildung von Abschattungen auf den Werkstücken vermieden werden kann.

Der kohlenstofffaserverstärkte Kohlenstoff kann ein textiles Fasergewebe oder ein Faservlies aufweisen. Das textile Fasergewebe kann ein sogenanntes 3K-, 6K- oder 12K-Gewebe sein. Derartige textile Fasergewebe oder Faservliese sind mit Harz vorimprägniert als Prepregs kostengünstig erhältlich, wodurch die Herstellung der Trägerplatte vereinfacht werden kann.

Die Werkstückaufnahmen können stiftförmig, einstückig und/oder durch spanende Bearbeitung ausgebildet sein. Da die Werkstückaufnahmen aus der Plattenebene der Trägerplatte vorspringen beziehungsweise hervorstehen, ist eine stiftförmige Ausbildung der Werkstückaufnahme besonders vorteilhaft. Auch kann vorgesehen sein, die Werkstückaufnahme einstückig auszubilden, wodurch die Werkstückaufnahme kostengünstig herstellbar wird. Je nach Art des zu handhabenden Werkstücks kann jedoch auch eine mehrteilige Ausbildung der Werkstückaufnahme erforderlich sein. Unabhängig davon ob die Werkstückaufnahme aus einem kohlenstofffaserverstärkten Kohlenstoff oder aus Graphit ausgebildet wird, kann eine spanende Bearbeitung der Werkstückaufnahme vorgesehen sein. Beispielsweise kann ein Rundstab aus kohlenstofffaserverstärktem Kohlenstoff oder Graphit mittels einer Drehmaschine einfach spanend bearbeitet und so eine große Anzahl von Werkstückaufnahmen kostengünstig hergestellt werden. Bei dem kohlenstofffaserverstärkten Kohlenstoff kann vorgesehen sein, dass sich Kohlenstofffasern im Wesentlichen in Richtung einer Längsrichtung beziehungsweise Längsachse der Werkstückaufnahme erstrecken.

Insofern ist es vorteilhaft, wenn die Werkstückaufnahme rotationssymmetrisch ausgebildet ist. Gleichwohl ist es auch möglich, die Werkstückaufnahme rechteckig oder quadratisch auszubilden. Beispielsweise kann die Werkstückaufnahme auch aus einer Platte aus kohlenstofffaserverstärktem Kohlenstoff ausgeschnitten werden.

In der Trägerplatte können Befestigungsausnehmungen ausgebildet sein, in die die Werkstückaufnahmen eingesetzt sein können. Die Befestigungsausnehmungen können Durchgangsöffnungen, Bohrungen oder Sacklochbohrungen sein, in die die Werkstückaufnahmen jeweils eingesetzt sind. Die Befestigungsausnehmungen können so ausgebildet werden, dass in den Befestigungsausnehmungen und den Werkstückaufnahmen jeweils eine Passung, vorzugsweise eine Presspassung oder Übergangspassung, ausgebildet ist. Eine Montage des Werkstückträgers kann dann besonders einfach dadurch erfolgen, dass die Werkstückaufnahmen in die Befestigungsausnehmungen eingesteckt werden. Auch können beschädige Werkstückaufnahmen dann einfach ersetzt werden.

Die Werkstückaufnahme kann einen Befestigungssockel aufweisen, der in die Befestigungsausnehmung eingesetzt sein kann. Wenn die Befestigungsausnehmung eine Bohrung ist, kann der Befestigungssockel ein übereinstimmend ausgebildeter Fortsatz sein, der die Bohrung im Wesentlichen ausfüllt.

Kohlenstofffasern der Trägerplatte können an einer Innenfläche der Befestigungsausnehmung in eine Außenfläche des Befestigungssockels eingreifen. Dadurch wird es möglich, auch ohne Ausbildung einer Presspassung zwischen dem Befestigungssockel und der Befestigungsausnehmung eine besonders innige Verbindung von Trägerplatte und Werkstückaufnahme auszubilden. Die Werkstückaufnahme kann dann besonders einfach in den Befestigungssockel ohne großen Kraftaufwand eingesteckt, jedoch nur noch schwer entfernt werden, da sich die Kohlenstofffasern der Trägerplatte mit dem Befestigungssockel verhaken beziehungsweise in diesen eingreifen. Dieser Effekt kann noch einmal verstärkt werden, wenn die Werkstückaufnahme aus kohlenstofffaserverstärkten Kohlenstoff ausgebildeten ist, so dass auch die Kohlenstofffasern der Werkstückaufnahmen in die Innenfläche der Befestigungsausnehmung eingreifen können. Durch diese Art der Befestigung kann ein unbeabsichtigtes Lösen einer Werkstückaufnahme aus der Trägerplatte infolge von Temperaturschwankungen und auch bei einer Entschichtung des Trägers verhindert werden.

Die Werkstückaufnahme kann einen Basisabschnitt aufweisen, der an einer Oberfläche der Trägerplatte anliegt. Der Basisabschnitt bildet demnach einen Anschlag aus, der sicherstellt, dass die Werkstückaufnahme nur ein stückweit in die Trägerplatte eingesteckt wird und stets gleichmäßig und gerade aus der Plattenebene der Trägerplatte hervorsteht. Der Basisabschnitt kann einen eventuell vorhandenen Befestigungssockel überragen.

In einer Ausführungsform kann vorgesehen sein, die jeweiligen Basisabschnitte der Werkstückaufnahmen so miteinander zu verbinden, dass eine Reihenanordnung von Werkstückaufnahmen ausgebildet ist. Die Werkstückaufnahmen können dann zusammenhängend, beispielsweise leistenförmig oder in Art einer Kette ausgebildet sein. So ist es möglich, eine Mehrzahl von Werkstückaufnahmen dadurch herzustellen, dass aus einem plattenförmigen Material eine Leiste oder Kette ausgeschnitten wird, die die Werkstückaufnahmen ausbildet. Dann ist es auch ausreichend nur wenige Befestigungsausnehmungen in der Trägerplatte auszubilden. Prinzipiell ist es möglich, die Werkstückaufnahmen in jedem beliebigen, zur Aufnahme von Werkstücken geeigneten Muster auf der Trägerplatte anzuordnen. Auch kann vorgesehen sein, derartige Werkstückaufnahmen relativ zueinander kreuzweise anzuordnen.

Die Werkstückaufnahme kann ein Aufnahmeende aufweisen, das zur Halterung eines Werkstücks ausgebildet ist, wobei das Aufnahmeende einen sich verjüngenden Anlageabschnitt zur Anlage eines Werkstücks ausbilden kann. Zumindest das Aufnahmeende kann dann aus der Plattenebene der Trägerplatte vorspringen. Durch den sich verjüngenden Auflageabschnitt wird es auch möglich, Werkstücke so auf die Werkstückaufnahme aufzustecken beziehungsweise darauf abzulegen, dass lediglich ein punktförmiger oder linienförmiger Auflagekontakt zwischen dem Werkstück und der Werkstückaufnahme ausgebildet wird. Eine Oberfläche des Werkstücks kann dann im Wesentlichen vollständig beschichtet werden.

Das Aufnahmeende kann bezogen auf eine Längsschnittebene durch eine Längsachse der Werkstückaufnahme eine Außenkontur ausbilden, wobei die Außenkontur im Bereich des Auflageabschnitts als eine relativ zur Längsachse geneigte Gerade, als ein elliptischer Bogen, als ein Radius und/oder mit zwei oder mehr unterschiedlichen Radien ausgebildet sein kann. Durch eine derartige Ausbildung der Außenkontur kann beispielsweise auch eine Zentrierung des Werkstücks auf dem Werkstückträger einfach erfolgen.

Das Aufnahmeende kann einen stabförmigen Aufsteckabschnitt zur Halterung eines Werkstücks ausbilden. Der Aufsteckabschnitt kann demnach geradförmig oder zylindrisch als ein Fortsatz des Auflageabschnitts ausgebildet sein. Insbesondere wenn das Werkstück eine Bohrung aufweist, kann das Werkstück dann besonders sicher auf der Werkstückaufnahme dadurch gehaltert werden, dass der Aufsteckabschnitt in die Bohrung eingesetzt wird.

Demnach kann der Aufsteckabschnitt vorteilhaft an den Auflageabschnitt anschließen.

Bei dem erfindungsgemäßen Verfahren zur Instandsetzung eines erfindungsgemäßen Werkstückträgers weist eine Oberfläche des Werkstückträgers eine aus einem Beschichtungsmaterial ausgebildete Beschichtung auf, wobei die Beschichtung mittels einer chemischen Reaktion des Beschichtungsmaterials mit einer Säure oder Base, thermisch und/oder mechanisch entfernt wird. Dadurch wird es möglich, den Werkstückträger wiederholt von dem Beschichtungsmaterial zu befreien und wiederzuverwenden. Weitere vorteilhafte Ausführungsformen des Verfahrens ergeben sich aus den Merkmalsbeschreibungen der auf den Vorrichtungsanspruch 1 rückbezogenen Unteransprüche.

Erfindungsgemäß wird kohlenstofffaserverstärkter Kohlenstoff zur Herstellung eines erfindungsgemäßen Werkstückträgers verwendet. Weitere vorteilhafte Ausführungsformen der Verwendung ergeben sich aus den Merkmalsbeschreibungen der auf den Vorrichtungsanspruch 1 rückbezogenen Unteransprüche.

Bei dem erfindungsgemäßen Verfahren zur Herstellung eines Werkstückträgers zum Bereitstellen und Handhaben von Werkstücken in Hochtemperaturöfen zur Werkstückbeschichtung oder dergleichen, wird der Werkstückträger aus einer Trägerplatte mit aus einer Plattenebene der Trägerplatte vorspringenden Werkstückaufnahmen ausgebildet, wobei der Werkstückträger aus einem Kohlenstoffmaterial ausgebildet wird, wobei der Werkstückträger mehrteilig ausgebildet wird, wobei zumindest die Trägerplatte aus kohlenstofffaserverstärktem Kohlenstoff ausgebildet wird. Zu den Vorteilen des erfindungsgemäßen Verfahrens wird auf die Vorteilsbeschreibung der erfindungsgemäßen Vorrichtung verwiesen.

Der Werkstückträger kann vor einer erstmaligen Verwendung aus der Gasphase mit einem Beschichtungsmaterial vorbeschichtet werden. Dadurch kann ein zumindest teilweiser beziehungsweise vollständiger Verschluss von Poren in der Trägerplatte beziehungsweise dem Werkstückträger mit dem Beschichtungsmaterial erfolgen. Damit kann dann sichergestellt werden, dass bei der erstmaligen Verwendung des Werkstückträgers zur Beschichtung von Werkstücken nicht zu viel Beschichtungsmaterial für die Beschichtung des Werkstückträgers aufgebraucht wird und bei allen aufeinanderfolgenden Beschichtungsprozessen stets die gleiche Menge an Beschichtungsmaterial erforderlich ist. Darüber hinaus kann durch die Vorbeschichtung besonders gut eine Haftschicht für nachfolgende Beschichtungen mit Beschichtungsmaterial ausgebildet werden, die ein Abplatzen von Beschichtungsmaterial verhindert.

Weitere vorteilhafte Ausführungsformen des Verfahrens ergeben sich aus den Merkmalsbeschreibungen der auf den Vorrichtungsanspruch 1 rückbezogenen Unteransprüche.

Nachfolgend werden bevorzugte Ausführungsformen der Erfindung unter Bezugnahme auf die beigefügten Zeichnungen näher erläutert.

Es zeigen:
- **Fig. 1**: eine erste Ausführungsform einer Trägerplatte in einer Draufsicht;
- **Fig. 2**: eine Seitenansicht der Trägerplatte aus **Fig. 1**;
- **Fig. 3**: eine zweite Ausführungsform einer Trägerplatte in einer Draufsicht;
- **Fig. 4**: eine erste Ausführungsform einer Werkstückaufnahme in einer Seitenansicht;
- **Fig. 5**: eine Schnittansicht der Werkstückaufnahme aus **Fig. 4** in einer Trägerplatte;
- **Fig. 6**: eine zweite Ausführungsform einer Werkstückaufnahme in einer Seitenansicht;
- **Fig. 7**: eine dritte Ausführungsform einer Werkstückaufnahme in einer Seitenansicht;
- **Fig. 8**: eine vierte Ausführungsform einer Werkstückaufnahme in einer Seitenansicht;
- **Fig. 9**: eine fünfte Ausführungsform einer Werkstückaufnahme in einer Seitenansicht;
- **Fig. 10**: Längsschnittansicht der Werkstückaufnahme aus **Fig. 9****;**
- **Fig. 11**: eine perspektivische Ansicht der Werkstückaufnahme aus **Fig. 9**.

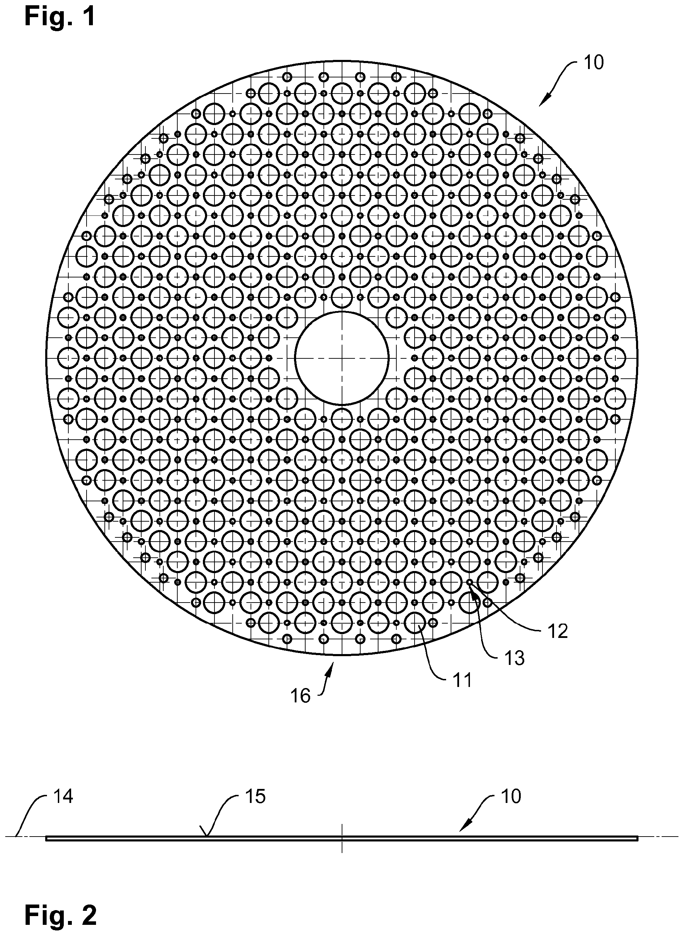

Eine Zusammenschau der **Fig. 1** und **2** zeigt eine Trägerplatte 10 eines hier nicht näher dargestellten Werkstückträgers, wobei die Trägerplatte 10 Durchgangsbohrungen 11 für einen Gasdurchtritt und Durchgangsbohrungen 12, die Befestigungsausnehmungen 13 für den nicht näher dargestellten Werkstückträger ausbilden, aufweist. In die Befestigungsausnehmungen 13 können die Werkstückaufnahmen eingesteckt werden, so dass die Werkstückaufnahmen eine Plattenebene 14 der Trägerplatte 10 beziehungsweise eine Oberfläche 15 überragen. Auf die Werkstückaufnahmen können dann Werkstücke aufgesetzt beziehungsweise aufgesteckt werden. Die Trägerplatte 10 kann dann zusammen mit den Werkstücken in einem Hochtemperaturofen mit einem Beschichtungsmaterial beschichtet werden. Die Beschichtung kann beispielsweise mittels eines CVD-Verfahrens erfolgen. Wie aus der **Fig. 1** ersichtlich wird, bilden die Durchgangsbohrungen 11 und 12 ein Lochraster 16 in der Trägerplatte 10 aus. Die Trägerplatte 10 ist aus kohlenstofffaserverstärktem Kohlenstoff (CFC) ausgebildet und wurde durch Aushärten und Graphitieren von mit Phenolharz getränkten Prepregs ausgebildet, wobei die Durchgangsbohrungen 11 und 12 zumindest nach dem Aushärten des Phenolharzes in die Trägerplatte 10 eingebracht wurden. Insbesondere handelt es sich bei der Kohlenstofffaserverstärkung um ein 12K-Fasergewebe. Ein Durchmesser der Durchgangsbohrungen 11 ist um ein Vielfaches größer als ein Durchmesser der Durchgangsbohrungen 12. Nicht verschlossene Durchgangsbohrungen 11 und 12 können beispielsweise auch zur Positionserkennung durch einen Roboter oder zur Bestimmung einer Schichtdicke genutzt werden.

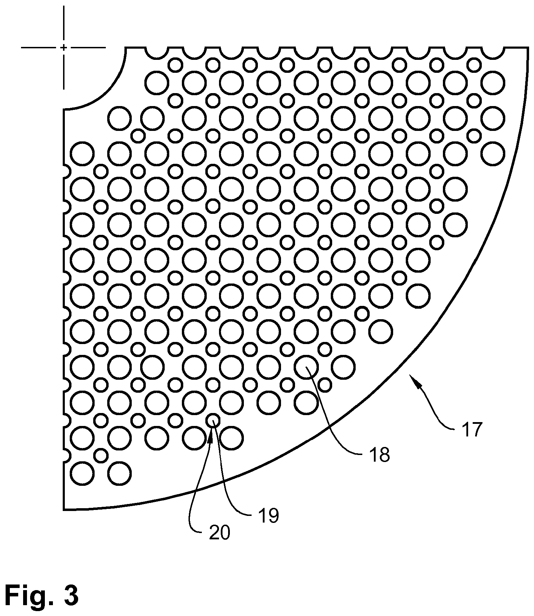

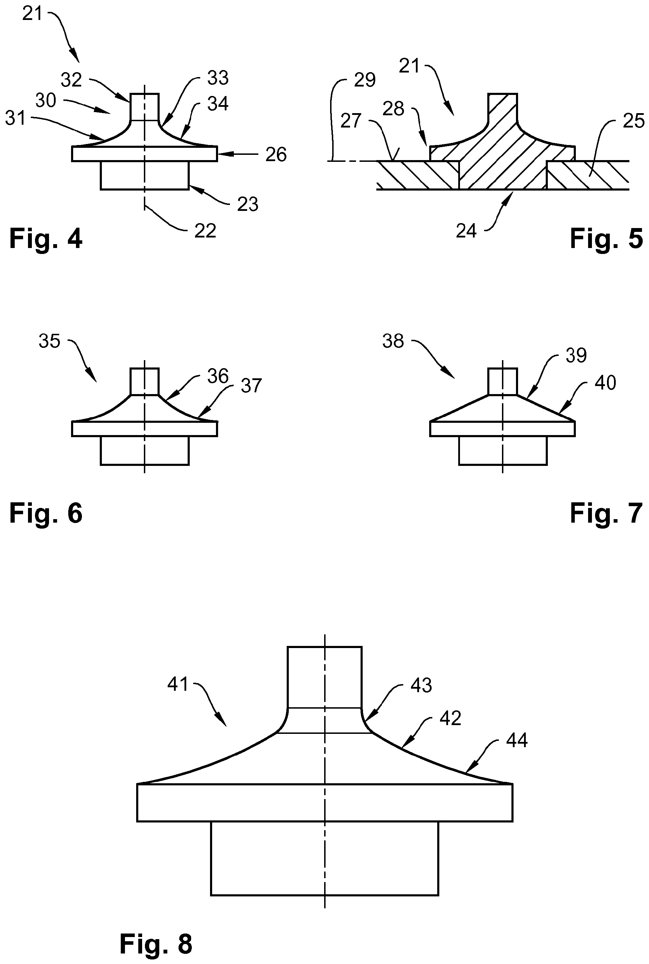

Die **Fig. 3** zeigt eine weitere Ausführungsform einer Trägerplatte 17, von der hier lediglich ein Viertel eines Kreisabschnitts in einer Draufsicht dargestellt ist. Die Trägerplatte 17 weist ebenfalls Durchgangsbohrungen 18 für einen Gasdurchtritt und Durchgangsbohrungen 19 zur Ausbildung von Befestigungsausnehmungen 20 für Werkstückaufnahmen auf. Auch hier ist die Trägerplatte 17 aus einem kohlenstofffaserverstärkten Kohlenstoff ausgebildet. Eine Zusammenschau der **Fig. 4** und **5** zeigt eine Werkstückaufnahme 21, die stabförmig und einstückig aus einem kohlenstofffaserverstärkten Kohlenstoff ausgebildet ist. Die Werkstückaufnahme 21 kann jedoch auch alternativ aus Graphit ausgebildet werden. Die Werkstückaufnahme 21 ist relativ bezogen auf eine Längsachse 22 rotationssymmetrisch ausgebildet und weist einen Befestigungssockel 23 auf, der in eine Befestigungsausnehmung 24 einer Trägerplatte 25 einsetzbar beziehungsweise, wie in **Fig. 5** dargestellt, eingesetzt ist. Weiter bildet die Werkstückaufnahme 21 einen Basisabschnitt 20 aus, der an einer Oberfläche 27 der Trägerplatte 25 anliegt und so einen Anschlag 28 ausbildet. Der Befestigungssockel 23 ist demnach vollständig innerhalb der Trägerplatte 25 aufgenommen. Die Werkstückaufnahme 21 überragt eine Plattenebene 29 der Trägerplatte 25 mit dem Basisabschnitt 26 und einem Aufnahmeende 30. Das Aufnahmeende 30 bildet einen Auflageabschnitt 31 und einen Aufsteckabschnitt 32 aus. Der Aufsteckabschnitt 32 ist gerade, stabförmig ausgebildet und schließt an den Auflageabschnitt 31 an. Bezogen auf eine Längsschnittebene durch eine Längsachse 22 der Werkstückaufnahme 21 ist eine Außenkontur 33 des Auflageabschnitts 31 als ein elliptischer Bogen 34 ausgebildet.

Die **Fig. 6** zeigt eine Werkstückaufnahme 35, die im Unterschied zur Werkstückaufnahme aus **Fig. 4** eine Außenkontur 36 an dem Radius 37 aufweist.

Die **Fig. 7** zeigt eine Werkstückaufnahme 38, die im Unterschied zur Werkstückaufnahme aus **Fig. 4** eine Außenkontur 39 mit einer Geraden 40 aufweist.

Die **Fig. 8** zeigt eine Werkstückaufnahme 41, die im Unterschied zu der in **Fig. 4** gezeigten Werkstückaufnahme eine Außenkontur 42 mit einem ersten Radius 43 und einem zweiten Radius 44 aufweist.

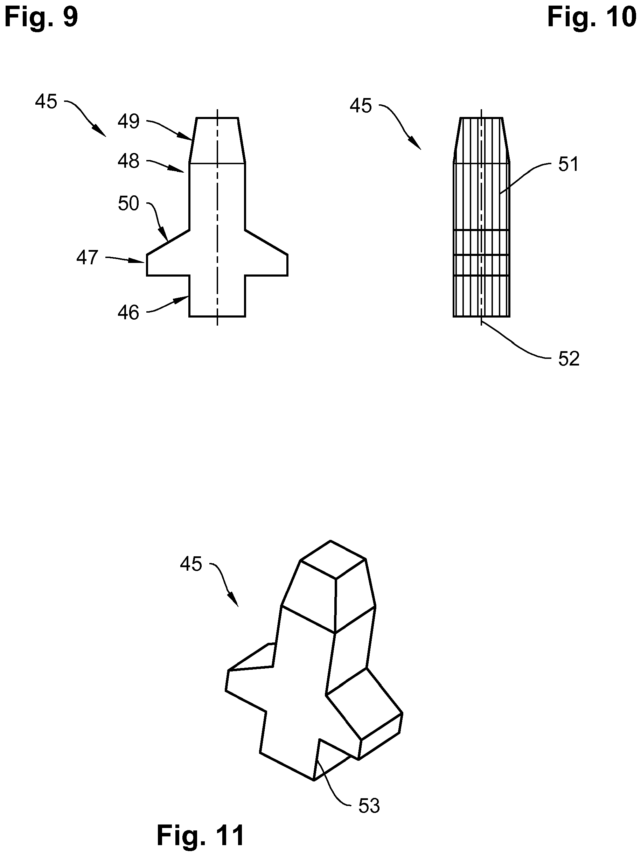

Eine Zusammenschau der **Fig. 9** bis **11** zeigt eine Werkstückaufnahme 45, die stiftförmig und aus einem kohlenstofffaserverstärkten Kohlenstoff ausgebildet ist. Die Werkstückaufnahme 45 weist einen Befestigungssockel 46, einen Basisabschnitt 47 und ein Aufnahmeende 48 mit einem Aufsteckabschnitt 49 auf. An dem Basisabschnitt 47 ist ein Auflageabschnitt 50 des Aufnahmeendes 48 ausgebildet. Hier andeutungsweise dargestellte Kohlenstofffasern 51 verlaufen parallel zu einer Längsachse 52 der Werkstückaufnahme 45. Die Werkstückaufnahme 45 kann in eine hier nicht dargestellte Befestigungsausnehmung beziehungsweise Durchgangsbohrung einer Trägerplatte eingesteckt werden, wobei Seitenkanten 55 des Befestigungssockels 46 dann an einer Innenfläche der Befestigungsausnehmung so anliegen, dass der Befestigungssockel 46 in der Durchgangsbohrung geklemmt ist.

## Patentansprüche

1. Werkstückträger zum Bereitstellen und Handhaben von Werkstücken in Hochtemperaturöfen zur Werkstückbeschichtung, wobei der Werkstückträger aus einer Trägerplatte (10, 17, 25) mit aus einer Plattenebene (14, 29) der Trägerplatte vorspringenden Werkstückaufnahmen (21, 35, 38, 41, 45) ausgebildet ist, wobei der Werkstückträger aus einem Kohlenstoffmaterial ausgebildet ist,
**dadurch gekennzeichnet,**
**dass** der Werkstückträger mehrteilig ausgebildet ist, wobei zumindest die Trägerplatte aus kohlenstofffaserverstärkten Kohlenstoff ausgebildet ist und wobei die Trägerplatte (10, 17, 25) ein Lochraster (16) aufweist.

2. Werkstückträger nach Anspruch 1,
**dadurch gekennzeichnet,**
**dass** die Werkstückaufnahmen (21, 35, 38, 41, 45) aus kohlenstofffaserverstärkten Kohlenstoff ausgebildet sind.

3. Werkstückträger nach Anspruch 1,
**dadurch gekennzeichnet,**
**dass** die Werkstückaufnahmen (21, 35, 38, 41, 45) aus Graphit ausgebildet sind.

4. Werkstückträger nach einem der vorangehenden Ansprüche,
**dadurch gekennzeichnet,**
**dass** der kohlenstofffaserverstärkte Kohlenstoff ein textiles Fasergewebe oder ein Faserflies aufweist.

5. Werkstückträger nach einem der vorangehenden Ansprüche,
**dadurch gekennzeichnet,**
**dass** die Werkstückaufnahme (21, 35, 38, 41, 45) stiftförmig, einstückig und/oder durch spanende Bearbeitung ausgebildet ist.

6. Werkstückträger nach einem der vorangehenden Ansprüche,
**dadurch gekennzeichnet,**
**dass** die Werkstückaufnahme (21, 35, 38, 41) rotationssymmetrisch ausgebildet ist.

7. Werkstückträger nach einem der vorangehenden Ansprüche,
**dadurch gekennzeichnet,**
**dass** in der Trägerplatte (10, 17, 25) Befestigungsausnehmungen (13, 20, 24) ausgebildet sind, in die die Werkstückaufnahmen (21, 35, 38, 41, 45) eingesetzt sind.

8. Werkstückträger nach Anspruch 7,
**dadurch gekennzeichnet,**
**dass** die Werkstückaufnahme (21, 35, 38, 41, 45) einen Befestigungssockel (23, 46) aufweist, der in die Befestigungsausnehmung (13, 20, 24) eingesetzt ist.

9. Werkstückträger nach Anspruch 8,
**dadurch gekennzeichnet,**
**dass** Kohlenstofffasern der Trägerplatte (10, 17, 25) an einer Innenfläche der Befestigungsausnehmung (13, 20, 24) in eine Außenfläche des Befestigungssockels (23, 46) eingreifen.

10. Werkstückträger nach einem der vorangehenden Ansprüche,
**dadurch gekennzeichnet,**
**dass** die Werkstückaufnahme (21, 35, 38, 41, 45) einen Basisabschnitt (26, 47) aufweist, der an einer Oberfläche (15, 27) der Trägerplatte (10, 17, 25) anliegt.

11. Werkstückträger nach Anspruch 10,
**dadurch gekennzeichnet,**
**dass** die jeweiligen Basisabschnitte der Werkstückaufnahmen so miteinander verbunden sind, dass eine Reihenanordnung von Werkstückaufnahmen ausgebildet ist.

12. Werkstückträger nach einem der vorangehenden Ansprüche,
**dadurch gekennzeichnet,**
**dass** die Werkstückaufnahme (21, 35, 38, 41, 45) ein Aufnahmeende (30, 48) aufweist, das zur Halterung eines Werkstücks ausgebildet ist, wobei das Aufnahmeende einen sich verjüngenden Auflageabschnitt (31, 50) zur Anlage eines Werkstücks ausbildet.

13. Werkstückträger nach Anspruch 12,
**dadurch gekennzeichnet,**
**dass** das Aufnahmeende (30, 48), bezogen auf eine Längsschnittebene durch eine Längsachse (22, 52) der Werkstückaufnahme (21, 35, 38, 41, 45), eine Außenkontur (33, 36, 39, 42) ausbildet, wobei die Außenkontur im Bereich des Auflageabschnitts als eine relativ zur Längsachse geneigte Gerade (40), als ein elliptischer Bogen (34), als ein Radius (37) oder mit zwei oder mehr unterschiedlichen Radien (43, 44) ausgebildet ist.

14. Werkstückträger nach Anspruch 12 oder 13,
**dadurch gekennzeichnet,**
**dass** das Aufnahmeende (30, 48) einen stabförmigen Aufsteckabschnitt (32, 49) zur Halterung eines Werkstücks ausbildet.

15. Werkstückträger nach Anspruch 14,
**dadurch gekennzeichnet,**
**dass** der Aufsteckabschnitt (32, 49) an den Auflageabschnitt (31, 50) anschließt.

16. Verfahren zur Instandsetzung eines Werkstückträgers nach einem der vorangehenden Ansprüche, wobei eine Oberfläche des Werkstückträgers eine aus einem Beschichtungsmaterial ausgebildete Beschichtung aufweist, wobei die Beschichtung mittels einer chemischen Reaktion des Beschichtungsmaterials mit einer Säure oder Base entfernt wird.

17. Verwendung von kohlenstofffaserverstärktem Kohlenstoff zur Herstellung eines Werkstückträgers nach einem der Ansprüche 1 bis 15.

18. Verfahren zur Herstellung eines Werkstückträgers zum Bereitstellen und Handhaben von Werkstücken in Hochtemperaturöfen zur Werkstückbeschichtung, wobei der Werkstückträger aus einer Trägerplatte (10, 17, 25) mit aus einer Plattenebene (14, 29) der Trägerplatte vorspringenden Werkstückaufnahmen (21, 35, 38, 41, 45) ausgebildet wird, wobei der Werkstückträger aus einem Kohlenstoffmaterial ausgebildet wird,
**dadurch gekennzeichnet,**
**dass** der Werkstückträger mehrteilig ausgebildet wird, wobei zumindest die Trägerplatte aus kohlenstofffaserverstärkten Kohlenstoff ausgebildet wird und wobei die Trägerplatte (10, 17, 25) ein Lochraster (16) aufweist.

19. Verfahren nach Anspruch 18,
**dadurch gekennzeichnet,**
**dass** der Werkstückträger vor einer erstmaligen Verwendung aus der Gasphase mit einem Beschichtungsmaterial vorbeschichtet wird.

## Claims

1. A workpiece carrier for providing and handling workpieces in high-temperature furnaces for workpiece coating, the workpiece carrier being realized by a carrier plate (10, 17, 25) having workpiece holders (21, 35, 38, 41, 45) projecting from a plate plane (14, 29) of the carrier plate, the workpiece carrier being made of a carbon material,
**characterized in that**
the workpiece carrier is made of several pieces, at least the carrier plate being made of carbon fiber reinforced carbon and the carrier plate (10, 17, 25) having a hole pattern (16).

2. The workpiece carrier according to claim 1,
**characterized in that**
the workpiece holders (21, 35, 38, 41, 45) are made of carbon fiber reinforced carbon.

3. The workpiece carrier according to claim 1,
**characterized in that**
the workpiece holders (21, 35, 38, 41, 45) are made of graphite.

4. The workpiece carrier according to any one of the preceding claims,
**characterized in that**
the carbon fiber reinforced carbon has a textile fibrous tissue or a fibrous web.

5. The workpiece carrier according to any one of the preceding claims,
**characterized in that**
the workpiece holder (21, 35, 38, 41, 45) is pin-shaped, integrally formed and/or formed by machining.

6. The workpiece carrier according to any one of the preceding claims,
**characterized in that**
the workpiece holder (21, 35, 38, 41) is rotationally symmetrical.

7. The workpiece carrier according to any one of the preceding claims,
**characterized in that**
fixing recesses (13, 20, 24) into which the workpiece holders (21, 35, 38, 41, 45) are inserted are formed in the carrier plate (10, 17, 25).

8. The workpiece carrier according to claim 7,
**characterized in that**
the workpiece holder (21, 35, 38, 41, 45) has a fixing base (23, 46) which is inserted into the fixing recess (13, 20, 24).

9. The workpiece carrier according to claim 8,
**characterized in that**
carbon fibers of the carrier plate (10. 17, 25) engage at an inner surface of the fixing recess (13, 20, 24) into an outer surface of the fixing base (23, 46).

10. The workpiece carrier according to any one of the preceding claims,
**characterized in that**
the workpiece holder (21, 35, 38, 41, 45) has a base portion (26, 47) which rests on a surface (15, 27) of the carrier plate (10, 17, 25).

11. The workpiece carrier according to claim 10,
**characterized in that**
the respective base portions of the workpiece holders are connected to one another in such a manner that a row arrangement of workpiece holders is formed.

12. The workpiece carrier according to any one of the preceding claims,
**characterized in that**
the workpiece holder (21, 35, 38, 41, 45) has a receiving end (30, 48) which is designed to hold a workpiece, the receiving end forming a tapering support portion (31, 50) on which a workpiece can rest.

13. The workpiece carrier according to claim 12,
**characterized in that**
the receiving end (30, 48) forms with respect to a longitudinal section plane through a longitudinal axis (22, 52) of the workpiece holder (21, 35, 38, 41, 45) an outer contour (33, 36, 39, 42), the outer contour being formed in the region of the support portion as a straight line (40) inclined relative to the longitudinal axis, as an elliptical arc (34), as a radius (37) or having two or more different radii (43, 44).

14. The workpiece carrier according to claim 12 or 13,
**characterized in that**
the receiving end (30, 48) forms a rod-shaped mounting portion (32, 49) for holding a workpiece.

15. The workpiece carrier according to claim 14,
**characterized in that**
the mounting portion (32, 49) adjoins the support portion (31, 50).

16. A method for the maintenance of a workpiece carrier according to any one of the preceding claims, wherein a surface of the work piece carrier has a coating made of a coating material, wherein the coating is removed by means of a chemical reaction of the coating material with an acid or a base.

17. Use of carbon fiber reinforced carbon for manufacturing a workpiece carrier according to any one of claims 1 to 15.

18. A method for manufacturing a workpiece carrier for providing and handling workpieces in high-temperature furnaces for workpiece coating, the workpiece carrier being realized by a carrier plate (10, 17, 25) having workpiece holders (21, 35, 38, 41, 45) projecting from a plate plane (14, 29) of the carrier plate, the workpiece carrier being made of a carbon material,
**characterized in that**
the workpiece carrier is made of several pieces, at least the carrier plate being made of carbon fiber reinforced carbon and the carrier plate (10, 17, 25) having a hole pattern (16).

19. The method according to claim 18,
**characterized in that**
the workpiece carrier is pre-coated from the gas phase with a coating material before it is used for the first time.

## Revendications

1. Porte-pièce pour fournir et manier des pièces de fabrication dans des fours à haute température pour le revêtement de pièces de fabrication, le porte-pièce étant réalisé par une plaque porteuse (10, 17, 25) ayant des réceptions (21, 35, 38, 41, 45) de pièces de fabrication faisant saillie d'un plan de plaque (14, 29) de la plaque porteuse, le porte-pièce étant fait d'un matériau de carbone,
**caractérisé en ce que**
le porte-pièce est réalisé en plusieurs parties, au moins la plaque porteuse étant fait d'un matériau composite carbone/carbone et la plaque porteuse (10, 17, 25) ayant une configuration de trous (16).

2. Porte-pièce selon la revendication 1,
**caractérisé en ce que**
les réceptions (21, 35, 38, 41, 45) de pièces de fabrication sont faites d'un matériau composite carbone/carbone.

3. Porte-pièce selon la revendication 1,
**caractérisé en ce que**
les réceptions (21, 35, 38, 41, 45) de pièces de fabrication sont faites de graphite.

4. Porte-pièce selon l'une quelconque des revendications précédentes,
**caractérisé en ce que**
le matériau composite carbone/carbone a un tissu textile en fibre ou un non-tissé.

5. Porte-pièce selon l'une quelconque des revendications précédentes,
**caractérisé en ce que**
la réception (21, 35, 38, 41, 45) de pièces de fabrication est en forme de tige, formée d'un seul tenant et/ou formée par usinage à l'outil.

6. Porte-pièce selon l'une quelconque des revendications précédentes,
**caractérisé en ce que**
la réception (21, 35, 38, 41) de pièces de fabrication est formée à symétrie de révolution.

7. Porte-pièce selon l'une quelconque des revendications précédentes,
**caractérisé en ce que**
des évidements de fixation (13, 20, 24) dans lesquels sont insérées les réceptions (21, 35, 38, 41, 45) de pièces de fabrication sont formés dans la plaque porteuse (10, 17, 25).

8. Porte-pièce selon la revendication 7,
**caractérisé en ce que**
la réception (21, 35, 38, 41, 45) de pièces de fabrication a une base de fixation (23, 46) qui est insérée dans l'évidement de fixation (13, 20, 24).

9. Porte-pièce selon la revendication 8,
**caractérisé en ce que**
des fibres de carbone de la plaque porteuse (10, 17, 25) sont mises en prise avec une surface extérieure de la base de fixation (23, 46) sur une surface intérieure de l'évidement de fixation (13, 20, 24).

10. Porte-pièce selon l'une quelconque des revendications précédentes,
**caractérisé en ce que**
la réception (21, 35, 38, 41, 45) de pièces de fabrication a une partie de base (26, 47) qui repose sur une surface (15, 27) de la plaque porteuse (10, 17, 25).

11. Porte-pièce selon la revendication 10,
**caractérisé en ce que**
les parties de base respectives des réceptions de pièces de fabrication sont reliées les unes aux autres de manière qu'une disposition en rangée des réceptions de pièces de fabrication est formée.

12. Porte-pièce selon l'une quelconque des revendications précédentes,
**caractérisé en ce que**
la réception (21, 35, 38, 41, 45) de pièces de fabrication a une extrémité de réception (30, 48) qui est formée pour retenir une pièce de fabrication, l'extrémité de réception formant une partie de support (31, 50) conique pour l'appui d'une pièce de fabrication.

13. Porte-pièce selon la revendication 12,
**caractérisé en ce que**
l'extrémité de réception (30, 48) forme par rapport à un plan de coupe longitudinale à travers un axe longitudinal (22, 52) de la réception (21, 35, 38, 41, 45) de pièces de fabrication un contour extérieur (33, 36, 39, 42), le contour extérieur étant formé dans la zone de la partie de support comme ligne droite (40) inclinée par rapport à l'axe longitudinal, comme arc elliptique (34), comme rayon (37) ou ayant deux ou plus rayons (43, 44) différents.

14. Porte-pièce selon la revendication 12 ou 13,
**caractérisé en ce que**
l'extrémité de réception (30, 48) forme une partie de fixation (32, 49) en forme de barre pour retenir une pièce de fabrication.

15. Porte-pièce selon la revendication 14,
**caractérisé en ce que**
la partie de fixation (32, 49) est contigüe à la partie de support (31, 50).

16. Procédé pour la remise en état d'un porte-pièce selon l'une quelconque des revendications précédentes, dans lequel une surface du porte-pièce a un revêtement fait d'un matériau de revêtement, dans lequel le revêtement est enlevé au moyen d'une réaction chimique du matériau de revêtement avec un acide ou une base.

17. Utilisation d'un matériau composite carbone/carbone pour la fabrication d'un porte-pièce selon l'une quelconque des revendications 1 à 15.

18. Procédé pour la fabrication d'un porte-pièce pour fournir et manier des pièces de fabrication dans des fours à haute température pour le revêtement de pièces de fabrication, le porte-pièce étant réalisé par une plaque porteuse (10, 17, 25) ayant des réceptions (21, 35, 38, 41, 45) de pièces de fabrication faisant saillie d'un plan de plaque (14, 29) de la plaque porteuse, le porte-pièce étant fait d'un matériau de carbone,
**caractérisé en ce que**
le porte-pièce est réalisé en plusieurs parties, au moins la plaque porteuse étant fait d'un matériau composite carbone/carbone et la plaque porteuse (10, 17, 25) ayant une configuration de trous (16)

19. Procédé selon la revendication 18,
**caractérisé en ce que**
le porte-pièce est, avant une première utilisation, pré-revêtu de la phase gazeuse avec un matériau de revêtement.
